# EUROPEAN PATENT APPLICATION

(11) **EP 3 761 077 A1**
(43) Date of publication of application: **06.01.2021**
(21) Application number: 18912934.9
(22) Date of filing: 27.03.2018
(51) Int. Cl.: G02B 5/20, G02F 1/13357, H01L 33/50

(54) **WAVELENGTH CONVERSION MEMBER, BACKLIGHT UNIT, IMAGE DISPLAY DEVICE, CURABLE COMPOSITION AND CURED PRODUCT**

(71) Applicant: Hitachi Chemical Company, Ltd., Chiyoda-ku, Tokyo 100-6606 (JP)
(72) Inventor: MUKAIGAITO, Kouhei, Tokyo 100-6606 (JP); YAHATA, Tatsuya, Tokyo 100-6606 (JP); KIRIGAYA, Kunihiro, Tokyo 100-6606 (JP)
(74) Representative: Berggren Oy, Tampere
(86) International application number: PCT/JP2018/012589
(87) International publication number: WO 2019/186734

(57) **Abstract**

The present invention provides a wavelength conversion member including a wavelength conversion layer, the wavelength conversion layer including a quantum dot phosphor, and having a structure derived from a hindered amine-based compound, and a sulfide structure.

## Description

### Technical Field

The present invention relates to a wavelength conversion member, a backlight unit, an image display device, a curable composition, and a cured product.

### Background Art

In the field of image display devices, such as liquid crystal display devices, an improvement in color reproducibility of displays is required, in recent years. As means for improving the color reproducibility, wavelength conversion members including quantum dot phosphors are drawing attentions, as disclosed in Japanese National-Phase Publication (JP-A) No. 2013-544018 and WO 2016/052625.

A wavelength conversion member including a quantum dot phosphor is disposed, for example, in a backlight unit of an image display device. In a case in which a wavelength conversion member including a quantum dot phosphor which emits red light and a quantum dot phosphor which emits green light is used, and when blue light as an exciting light is irradiated to the wavelength conversion member, it is possible to obtain white light by the combination of the red light and green light emitted from the quantum dot phosphors as well as the blue light transmitted through the wavelength conversion member.

The development of wavelength conversion members including quantum dot phosphors enabled to improve the color reproducibility of displays, from a conventional NTSC (National Television System Committee) ratio of 72% to a NTSC ratio of 100%. Further, a higher level of color reproducibility than the conventional NTSC standard tends to be required, due to an increasing demand for the color reproducibility in recent years. For example, the demand to meet higher standards such as DCI (Digital Cinema Initiatives)-P3 and Rec2020 is increasing.

As is known as a quantum size effect, changing the size of the quantum dot phosphors themselves allows for variously changing optical properties, such as absorption wavelength and emission wavelength of light, of the quantum dot phosphors. It is thought to be possible to increase the brightness of the white light to be obtained, or to enable designs which provide an excellent color reproducibility, by utilizing the above described properties and appropriately selecting the optical properties of the quantum dot phosphors.

### SUMMARY OF INVENTION

### Technical Problem

Quantum dot phosphors are susceptible to deterioration, when irradiated with light in the presence of water vapor, oxygen, and the like. Therefore, in a case in which a wavelength conversion member including a quantum dot phosphor is subjected to a light irradiation test, under both a high temperature environment as well as a high temperature and high humidity environment, the quantum dot phosphor may be deteriorated, possibly resulting in a decrease in emission intensity.

In order to reduce a decrease in the emission intensity due to the deterioration of the quantum dot phosphor, there is a case in which at least a part of a wavelength conversion layer including the quantum dot phosphor, included in the wavelength conversion member including the quantum dot phosphor, is coated with a coating material. For example, in the case of a wavelength conversion member in the form of a film, a coating material, more specifically, a barrier film having a barrier property against at least one of oxygen or water, may be provided on one surface or both surfaces of the wavelength conversion layer including the quantum dot phosphor. However, although a barrier film obtained by forming an inorganic layer including silica, alumina and/or the like, on a resin substrate such as a polyethylene terephthalate (PET) film, is capable of reducing the deterioration of the quantum dot phosphor because water vapor and oxygen are less likely to permeate therethrough, such a barrier film is expensive and causes an increase in the production cost of the resulting wavelength conversion member. Therefore, a replacement to a more inexpensive material has been desired.

However, when a material which is more inexpensive and more versatile than a barrier film, such as a PET film including no inorganic layer, is used as a coating material for such a wavelength conversion member, and subjected to a light irradiation test under both a high temperature environment as well as a high temperature and high humidity environment, a decrease in the emission intensity due to the deterioration of the quantum dot phosphor cannot be sufficiently reduced. This makes it difficult to provide a wavelength conversion member having a sufficient reliability. Accordingly, it is desirable to increase light resistance of a wavelength conversion layer including a quantum dot phosphor under both a high temperature environment as well as a high temperature and high humidity environment, and to thereby increase the light resistance of a wavelength conversion member including the wavelength conversion layer under both a high temperature environment as well as a high temperature and high humidity environment. Further, even in the case of using a barrier film, it is desirable to increase the light resistance of a wavelength conversion layer including a quantum dot phosphor under both a high temperature environment as well as a high temperature and high humidity environment, from the viewpoint of enhancing the reliability of a wavelength conversion member including the wavelength conversion layer.

The present disclosure has been made in view of the above described circumstances, and an object of the present disclosure is to provide: a wavelength conversion member including a wavelength conversion layer having an excellent light resistance under both a high temperature environment as well as a high temperature and high humidity environment; a backlight unit and an image display device using the same; a curable composition capable of forming a wavelength conversion layer having an excellent light resistance under both a high temperature environment as well as a high temperature and high humidity environment; and a cured product obtained by curing the same.

### Solution to Problem

Examples of specific means for achieving the objects are shown in the following embodiments.
<1> A wavelength conversion member comprising a wavelength conversion layer, the wavelength conversion layer comprising a quantum dot phosphor, and having a structure derived from a hindered amine-based compound, and a sulfide structure.
<2> A wavelength conversion member comprising a wavelength conversion layer, the wavelength conversion layer comprising a quantum dot phosphor and having a structure derived from a hindered amine-based compound, wherein a ratio (V1/V2) of a peak area (VI) attributed to C = C stretching vibration to a peak area (V2) attributed to S-H stretching vibration, in the wavelength conversion layer, as measured by a Fourier transformation infrared spectrophotometer, is 0.00052 or less.
<3> The wavelength conversion member according to <2>, wherein the wavelength conversion layer has a sulfide structure.
<4> The wavelength conversion member according to any one of <1> to <3>, wherein the wavelength conversion layer has a structure formed by copolymerization of the hindered amine-based compound.
<5> The wavelength conversion member according to <4>, wherein the structure formed by copolymerization of the hindered amine-based compound contains a structural unit represented by the following Formula (I): 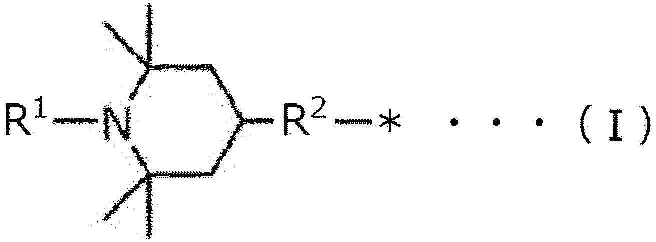 wherein in Formula (I), R¹ represents a hydrogen atom or a substituent; R² represents a linking group; and * represents a binding site.
<6> The wavelength conversion member according to any one of <1> to <5>, wherein the hindered amine-based compound comprises a compound represented by the following Formula (II): 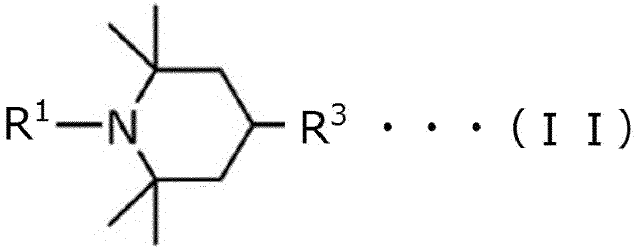 wherein in Formula (II), each of R¹ and R³ independently represents a hydrogen atom or a substituent.
<7> The wavelength conversion member according to any one of <1> to <6>, wherein the wavelength conversion layer has an alkyleneoxy structure.
<8> The wavelength conversion member according to any one of <1> to <7>, wherein the wavelength conversion member is a film.
<9> The wavelength conversion member according to any one of <1> to <8>, wherein the wavelength conversion member is used for displaying an image.
<10> The wavelength conversion member according to any one of <1> to <9>, wherein the quantum dot phosphor comprises a compound containing at least one of Cd or In.
<11> The wavelength conversion member according to any one of <1> to <10>, wherein the wavelength conversion member further comprises a coating material that coats at least a part of the wavelength conversion layer.
<12> Abacklight unit comprising: the wavelength conversion member according to any one of <1> to <11>; and a light source.
<13> An image display device comprising the backlight unit according to <12>.
<14> A curable composition comprising: a quantum dot phosphor; a hindered amine-based compound; a polyfunctional (meth)acrylate compound; a polyfunctional thiol compound; and a photopolymerization initiator.
<15> The curable composition according to <14>, wherein the hindered amine-based compound comprises a compound represented by the following Formula (II): 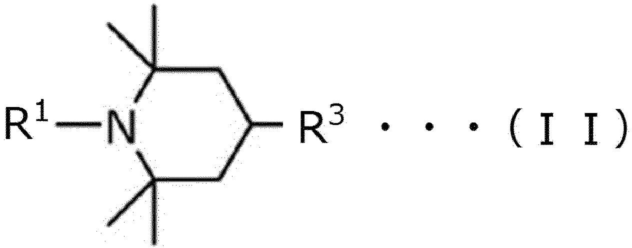 wherein in Formula (II), each of R¹ and R³ independently represents a hydrogen atom or a substituent.
<16> The curable composition according to <15>, wherein R³ in the compound represented by the Formula (II) comprises a polymerizable reactive group.
<17> The curable composition according to <16>, wherein the polymerizable reactive group is a (meth)acryloyl group.
<18> The curable composition according to any one of <14> to <17>, wherein the hindered amine-based compound is liquids at 20°C.
<19> The curable composition according to any one of <14> to <18>, wherein the quantum dot phosphor comprises a compound containing at least one of Cd or In.
<20> The curable composition according to any one of <14> to <19>, wherein the curable composition is used for forming a film.
<21> The curable composition according to any one of <14> to <20>, wherein the curable composition is used for producing a wavelength conversion member.
<22> A cured product obtained by curing the curable composition according to any one of <14> to <21>.

### Advantageous Effects of Invention

The present disclosure enables to provide: a wavelength conversion member including a wavelength conversion layer having an excellent light resistance under both a high temperature environment as well as a high temperature and high humidity environment; a backlight unit and an image display device using the same; a curable composition capable of forming a wavelength conversion layer having an excellent light resistance under both a high temperature environment as well as a high temperature and high humidity environment; and a cured product obtained by curing the same.

### BRIEF DESCRIPTION OF THE DRAWINGS

FIG. 1 is a schematic sectional view showing one example of a schematic configuration of a wavelength conversion member.
FIG. 2 is a diagram showing one example of a schematic configuration of a backlight unit.
FIG. 3 is a diagram showing one example of a schematic configuration of a liquid crystal display device.

### DESCRIPTION OF EMBODIMENTS

In the following, embodiments for implementing the invention are explained. However, the invention is not limited to these embodiments. The elements of the embodiments (including steps) are not essential, unless otherwise stated. The numbers and the ranges thereof do not limit the invention as well.
In the present disclosure, the "process" refers not only to a process that is independent from the other steps, but also to a step that cannot be clearly distinguished from the other steps, as long as the aim of the process is achieved.

In the present disclosure, the numerical range represented by "A to B" includes A and B as a minimum value and a maximum value, respectively.

In the present disclosure, when numerical ranges are described in a stepwise manner, the values of the upper or lower limit of each numerical range may be substituted by the values of the upper or lower limit of the other numerical range, or may be substituted by the values described in the Examples.

In the present disclosure, each component may include more than one kind of substances corresponding to a component. When there are more than one kind of substances corresponding to a component of a composition, the content or the content amount of the component refers to a total content or a total content amount of the substances, unless otherwise stated.

In the present disclosure, more than one kind of particles corresponding to a component may be included. When there are more than one kind of particles corresponding to a component of a composition, the particle size of the component refers to a particle size of a mixture of the more than one kind of particles.

In the present disclosure, the "layer" or "film" includes a state in which the layer or the film is formed over the entire region and a state in which the layer or the film is formed at a portion of the region, when the region is observed at which the layer or the film exists.

In the present disclosure, the "laminating" refers to disposing a layer on another layer, and the layers may be bonded together or may be detachable from each other.

In the present disclosure, the "(meth)acryloyl" refers to at least one of acryloyl or methacryloyl, the "(meth)acrylate" refers to at least one of acrylate or methacrylate, and the "(meth)allyl" refers to at least one of allyl or methallyl.

In the present disclosure, a compound having both a thiol group and an alkyleneoxy group is classified as a thiol compound.

In the present disclosure, the structure (O-R in -C(=O)-O-R, R represents substituent.) in which an oxygen atom in an ester bond, and a carbon atom adjacent to the oxygen atom are bonded, and the structure (O-R in HO-R, R represents substituent) in which an oxygen atom in a hydroxyl group, and a carbon atom are bonded, are not classified as an alkyleneoxy group.

### < Wavelength Conversion Member >

A wavelength conversion member according to the present disclosure includes a wavelength conversion layer which includes a quantum dot phosphor, and which has a structure derived from a hindered amine-based compound, and a sulfide structure.

If necessary, the wavelength conversion member according to the present disclosure may include any other component such as a coating material to be described later.

The wavelength conversion layer included in the wavelength conversion member according to the present disclosure may be a cured product obtained by curing a curable composition to be described later.

The wavelength conversion member according to the present disclosure is suitably used for displaying an image.

The wavelength conversion member according to the present disclosure has an excellent light resistance under a high humidity environment as well as a high temperature and high humidity environment, because the wavelength conversion layer includes a quantum dot phosphor and has a structure derived from a hindered amine-based compound.

In the present disclosure, the expression "wavelength conversion layer which has a structure derived from a hindered amine-based compound" refers to a wavelength conversion layer which has at least one of: a configuration in which a hindered amine-based compound is included in the wavelength conversion layer; or a configuration in which the wavelength conversion layer has a structure formed by copolymerization of a hindered amine-based compound containing a polymerizable reactive group with other resin components, specifically, with a polyfunctional (meth)acrylate compound, a polyfunctional thiol compound and the like to be described later.

Further, when the wavelength conversion layer has a sulfide structure, there is a tendency that it contributes to improving the polarity of the wavelength conversion layer, making non-polar oxygen less easily dissolved in the components in the wavelength conversion layer. This is thought to reduce the deterioration of the quantum dot phosphor due to oxygen, under a high humidity environment as well as a high temperature and high humidity environment, allowing the wavelength conversion layer to have an excellent light resistance. The sulfide structure may be one formed by a polymerization reaction of a thiol group in a polyfunctional thiol compound, with a carbon-carbon double bond in a polyfunctional (meth)acrylate compound, which are contained in the curable composition to be described later.

The wavelength conversion member according to the present disclosure may also be a wavelength conversion member including a wavelength conversion layer, in which the wavelength conversion layer includes a quantum dot phosphor and has a structure derived from a hindered amine-based compound, and in which the ratio (V1/V2) of a peak area (VI) attributed to C = C stretching vibration to a peak area (V2) attributed to S-H stretching vibration, in the wavelength conversion layer, as measured by a Fourier transformation infrared spectrophotometer, is 0.00052 or less. The wavelength conversion layer included in the wavelength conversion member may have a sulfide structure.

The ratio (V1/V2) is calculated by performing an FT-IR (Fourier transformation infrared spectrophotometer) measurement on the wavelength conversion layer, as described below. First, the surface of the wavelength conversion member to be measured is analyzed by ATR (Attenuated Total Reflection (total reflection measurement method)), using an FT-IR Spectrometer (manufactured by PerkinElmer). A background measurement is carried out by measuring air, and the FT-IR measurement was carried out under the condition of a cumulative number of 16 times. In a case in which the wavelength conversion member includes a coating material, the wavelength conversion layer in the wavelength conversion member, in a state where the coating material has been peeled off, is subjected to the FT-IR measurement.

The following peak areas V1 and V2 are determined for the wavelength conversion layer, by the above described FT-IR measurement.
VI: the peak area of the peak (peak wavelength: 1,637 cm⁻¹) attributed to C = C stretching vibration
V2: the peak area of the peak (peak wavelength: 2,569 cm⁻¹) attributed to S-H stretching vibration

The ratio (V1/V2) is more preferably 0.0001 or less, still more preferably 0.000087 or less, particularly preferably 0.000065 or less, even more preferably 0.00005 or less, and still even more preferably 0.000048 or less.

The ratio (V1/V2) may be 0.00001 or more, 0.00003 or more, or 0.000033 or more.

In a case in which the wavelength conversion layer is one formed by a polymerization reaction of a thiol group in a polyfunctional thiol compound with a carbon-carbon double bond in a polyfunctional (meth)acrylate compound, a higher value of the ratio (V1/V2) suggests, namely, the presence of a larger amount of thiol groups not contributing to the polymerization reaction. The presence of a larger amount of thiol groups not contributing to the polymerization reaction tends to result in a lower glass transition temperature of the wavelength conversion layer, and thus, a better workability of the wavelength conversion layer.

Further, the presence of a larger amount of thiol groups not contributing to the polymerization reaction tends to result in the coordination of unreacted thiol groups to the quantum dot phosphor, leading to a reduction in the deterioration of the quantum dot phosphor.

The wavelength conversion layer preferably has a structure formed by copolymerization of the hindered amine-based compound. In this case, a wavelength conversion layer which has a structure formed by copolymerization of the hindered amine-based compound with other resin components, specifically, with a polyfunctional (meth)acrylate compound, a polyfunctional thiol compound and the like to be described later, is obtained. This leads to a tendency that the exudation of the hindered amine-based compound, and the like can be reduced, and that the effects of the hindered amine-based compound are more suitably exhibited in the wavelength conversion layer.

The structure formed by copolymerization of the hindered amine-based compound may be a structure formed using a curable composition which contains a hindered amine-based compound containing a polymerizable reactive group, a polyfunctional (meth)acrylate compound and a polyfunctional thiol compound, and by a polymerization reaction of the polymerizable reactive group in the hindered amine-based compound with a carbon-carbon double bond in the polyfunctional (meth)acrylate compound and a thiol group in the polyfunctional thiol compound.

The structure formed by copolymerization of the hindered amine-based compound preferably contains, for example, a structural unit represented by the following Formula (I).

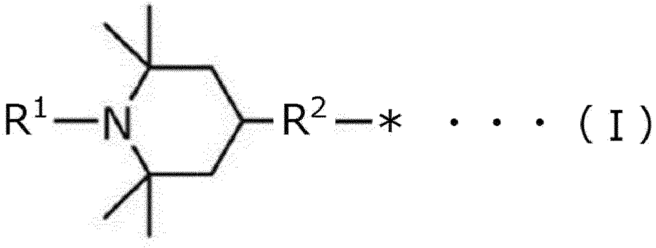

In Formula (I), R¹ represents a hydrogen atom or a substituent; R² represents a linking group; and * represents a binding site.

More specific examples of R¹ include a hydrogen atom, an alkyl group, and an alkoxy group. Among these, R¹ is preferably an alkyl group or an alkoxy group, and more preferably a methyl group or an n-undecanoxy group.

More specific examples of R² include an ester structure (-O-C(=O)-) and an alkylene group having the ester structure.

Hydrogen atoms in the alkyl group, the alkoxy group and the alkylene group represented by R¹ and R² may each be substituted with a halogen atom, a functional group or the like.

The hindered amine-based compound preferably contains, for example, a compound represented by the following Formula (II).

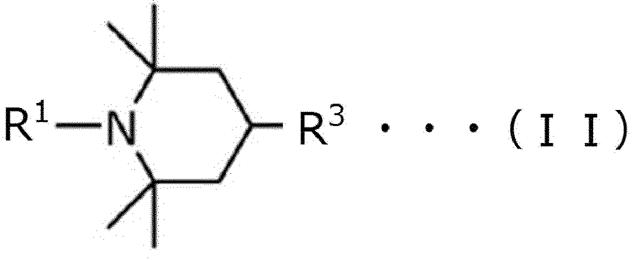

In Formula (II), each of R¹ and R³ independently represents a hydrogen atom or a substituent. Preferred examples of R¹ are the same as those described for R¹ in the above described Formula (I).

R³ is preferably a substituent having the ester structure (-O-C(=O)-).

The wavelength conversion layer may contain both a structural unit represented by the above described Formula (I) and a compound represented by the above described Formula (II), or may contain two or more kinds of compounds represented by the above described Formula (II).

For example, the wavelength conversion layer may be obtained by curing a curable composition containing, as the compounds represented by the above described Formula (II), a compound in which R³ contains a polymerizable reactive group and a compound in which R³ does not contain a polymerizable reactive group. By this arrangement, the compound in which R³ contains a polymerizable reactive group is reacted to form a structural unit represented by the above described Formula (I), and as a result, the wavelength conversion layer to be produced contains both the structural unit represented by the above described Formula (I) which is derived from the compound in which R³ contains a polymerizable reactive group, and the compound represented by the above described Formula (II).

The wavelength conversion layer preferably has an alkyleneoxy structure. When the wavelength conversion layer has an alkyleneoxy structure, there is a tendency that it contributes to improving the polarity of the wavelength conversion layer, making non-polar oxygen less suitably and easily dissolved in the components in the wavelength conversion layer. The alkyleneoxy structure may be, for example, derived from an alkyleneoxy group in a polyfunctional (meth)acrylate compound containing an alkyleneoxy group, which can be contained in the curable composition.

Further, the wavelength conversion layer may have an alicyclic structure. The alicyclic structure may be, for example, derived from an alicyclic structure in a polyfunctional (meth)acrylate compound containing an alicyclic structure, which can be contained in the curable composition.

The alicyclic structure which can be contained in the wavelength conversion layer is not particularly limited. Specific examples of the alicyclic structure include a tricyclodecane skeleton, a cyclohexane skeleton, a 1,3-adamantane skeleton, a hydrogenated bisphenol A skeleton, a hydrogenated bisphenol F skeleton, a hydrogenated bisphenol S skeleton, and an isobornyl skeleton. The wavelength conversion layer may contain one kind of alicyclic structure singly, or at least two kinds of alicyclic structures.

Further, the wavelength conversion layer may have an ester structure. The ester structure may be, for example, derived from an ester structure in a (meth)acryloyloxy group in a polyfunctional (meth)acrylate compound, which can be contained in the curable composition.

The wavelength conversion layer may include a white pigment. The details of the white pigment to be included in the wavelength conversion layer are as will be described in the section of the curable composition to be described later.

The details of the quantum dot phosphor and the hindered amine-based compound to be included in the wavelength conversion layer are also as will be described in the section of the curable composition to be described later.

The preferred ranges of the contents of the respective components, such as the quantum dot phosphor, the hindered amine-based compound and the white pigment, with respect to the total amount of the wavelength conversion layer are the same as the preferred ranges of the contents of the respective components with respect to the total amount of the curable composition.

The shape of the wavelength conversion member is not particularly limited, and the wavelength conversion member may be in the form of a film, a lens, or the like. In a case in which the wavelength conversion member is used in a backlight unit to be described later, the wavelength conversion member is preferably in the form of a film.

In a case in which the wavelength conversion layer is in the form of a film, the wavelength conversion layer preferably has an average thickness of, for example, from 50 µm to 200 µm, more preferably from 50 µm to 150 µm, and still more preferably from 80 µm to 120 µm. When the wavelength conversion layer has an average thickness of 50 µm or more, wavelength conversion efficiency tends to be further improved. When the wavelength conversion layer has an average thickness of 200 µm or less, and in a case in which the wavelength conversion layer is used in the backlight unit to be described later, there is a tendency that the thickness of the backlight unit can further be reduced.

The average thickness of the wavelength conversion layer in the form of a film is determined, for example, by: measuring the thickness of the wavelength conversion layer at arbitrarily selected three locations, using a micrometer, or using an SEM (scanning electron microscope) to observe a cross section of the wavelength conversion layer; and calculating an arithmetic mean value of the measured thicknesses, as the average thickness.

In the case of determining the average thickness of the wavelength conversion layer from a wavelength conversion member which is in the form of a film and which includes a plurality of layers, the average thickness of the wavelength conversion layer may be determined as follows. Specifically, the average thickness of the wavelength conversion member as well as the average thickness of the portion of the wavelength conversion member excluding the wavelength conversion layer (for example, the average thickness of the coating material(s)) are determined as described above, using a micrometer; and the average thickness of the portion of the wavelength conversion member excluding the wavelength conversion layer is subtracted from the average thickness of the wavelength conversion member.

Alternatively, in the case of determining the average thickness of the wavelength conversion layer from a wavelength conversion member which is in the form of a film and which includes a plurality of layers, the average thickness of the wavelength conversion layer is determined as follows. Specifically, the thickness of the wavelength conversion layer is measured at arbitrarily selected three locations, using a reflection spectroscopic film thickness meter or the like, or using an SEM (scanning electron microscope) to observe a cross section of the wavelength conversion layer; and the arithmetic mean value of the measured thicknesses is calculated as the average thickness.

The wavelength conversion member may be one formed by curing one kind of curable composition, or may be one formed by curing two or more kinds of curable compositions. For example, in a case in which the wavelength conversion member is in the form of a film, the wavelength conversion member may be one in which a first wavelength conversion layer obtained by curing a curable composition containing a first quantum dot phosphor, and a second wavelength conversion layer obtained by curing a curable composition containing a second quantum dot phosphor whose luminescence properties are different from those of the first quantum dot phosphor, are disposed one on another in layers.

The wavelength conversion member can be obtained by forming a coating film, a molded product or the like of the curable composition, and performing a drying treatment, if necessary, followed by irradiation of an active energy ray such as UV light. The wavelength and irradiation dose of the active energy ray can be set as appropriate, depending on the composition of the curable composition to be used. In one embodiment, UV light having a wavelength of from 280 nm to 400 nm is irradiated at an irradiation dose of from 100 mJ/cm² to 5,000 mJ/cm². Examples of a UV light source to be used include a low pressure mercury lamp, a medium pressure mercury lamp, a high pressure mercury lamp, an ultra-high pressure mercury lamp, a carbon arc lamp, a metal halide lamp, a xenon lamp, a chemical lamp, a black light lamp, and a microwave-excited mercury lamp.

The wavelength conversion layer preferably has a glass transition temperature (Tg) of 47°C or lower, more preferably from 0°C to 47°C, still more preferably from 10°C to 47°C, and particularly preferably from 15°C to 21°C, from the viewpoint of further improving adhesion and workability. The glass transition temperature (Tg) of the wavelength conversion layer can be measured using a dynamic viscoelasticity measuring apparatus (for example, Solid Analyzer, RSA-III, manufactured by Rheometric Scientific Inc.), at a frequency of 10 Hz.

Further, the wavelength conversion layer preferably has a storage modulus, as measured under the conditions of a frequency of 10 Hz and a temperature of 25°C, of from 1 × 10³ Pa to 1 × 10¹⁰ Pa, more preferably from 1 × 10⁴ Pa to 1 × 10⁹ Pa, and still more preferably from 1 × 10⁵ Pa to 1 × 10⁷ Pa, from the viewpoint of improving adhesion and heat resistance. The storage modulus of the wavelength conversion layer can be measured using a dynamic viscoelasticity measuring apparatus (for example, Solid Analyzer, RSA-III, manufactured by Rheometric Scientific Inc.).

The wavelength conversion layer preferably has a water vapor permeability, as measured under the conditions of a temperature of 40°C and a relative humidity of 70%, of 20 g/(m²·day) or more, more preferably 40 g/(m²·day) or more, still more preferably 60 g/(m²·day) or more, particularly preferably 80 g/(m²·day) or more, and even more preferably 100 g/(m²·day) or more. When the wavelength conversion layer has a water vapor permeability equal to or higher than a certain value, the wavelength conversion layer has a high polarity, and non-polar oxygen is less easily dissolved in the components (such as the resin components) in the wavelength conversion layer. As a result, it is assumed that oxidative degradation of the quantum dot phosphor in the wavelength conversion layer is suitably reduced.

The above described water vapor permeability is preferably 300 g/(m²·day) or less, more preferably 250 g/(m²·day) or less, still more preferably 230 g/(m²·day) or less, and particularly preferably 210 g/(m²·day) or less, from the viewpoint of maintaining the shape of the wavelength conversion layer, and improving the strength of the wavelength conversion layer.

The water vapor permeability of the wavelength conversion layer can be measured in accordance with the method described in JIS Z 0208:1976. Specifically, 10 g of calcium chloride is weighed into a water-vapor permeable cup; each wavelength conversion layer is fixed to the water-vapor permeable cup such that the exposed portion thereof has a diameter of 6 cm; the resultant is left to stand still under the conditions of a temperature of 40°C and a relative humidity of 70% for 24 hours, to determine the change in mass of the wavelength conversion layer; and the water vapor permeability is calculated from the thus determined change in mass.

When the wavelength conversion layer has a an alkyleneoxy structure, preferably, when the wavelength conversion layer is formed by curing a curable composition containing a polyfunctional (meth)acrylate compound containing an alkyleneoxy group, the Tg, the storage modulus and the water vapor permeability of the wavelength conversion layer tend to be easily adjusted to the above described ranges.

The wavelength conversion member according to the present disclosure may further include a coating material coating at least a part of the wavelength conversion layer. For example, in a case in which the wavelength conversion layer is in the form of a film, one surface or both surfaces of the film-like wavelength conversion layer may be coated with a coating material(s) in the form of a film.

The coating material preferably has a barrier property against oxygen, from the viewpoint of reducing a decrease in the luminous efficiency of the quantum dot phosphor.

In a case in which the wavelength conversion member includes a coating material, the coating material may be made of any material, without particular limitation. For example, a resin may be used as a material. The type of the resin is not particularly limited, and examples thereof include: polyesters such as polyethylene terephthalate (PET) and polyethylene naphthalate (PEN); polyolefins such as polyethylene (PE) and polypropylene (PP); polyamides such as Nylon; and ethylene-vinyl alcohol copolymers (EVOH). Further, the coating material may be one (a barrier film) including a barrier layer for enhancing barrier function. The barrier layer may be, for example, an inorganic layer containing an inorganic matter(s) such as alumina and/or silica.

The coating material may have a monolayer structure or a multi-layer structure. In a case in which the coating material has a multi-layer structure, the coating layer may be a combination of two or more layers made of different materials.

In a case in which the coating material is in the form of a film, the coating material has an average thickness of, for example, preferably from 50 µm to 150 µm, more preferably from 60 µm to 140 µm, and still more preferably from 70 µm to 135 µm. When the average thickness is 50 µm or more, the coating material tends to have a sufficient function such as barrier property; whereas when the average thickness is 150 µm or less, a decrease in light transmittance tends to be reduced.

The average thickness of the coating material in the form of a film is determined in the same manner as the average thickness of the wavelength conversion member in the form of a film.

The coating material preferably contains EVOH, from the viewpoint of achieving a reduction in cost, while maintaining the reliability of the wavelength conversion member. Although a coating material containing EVOH tends to have a water barrier property lower than that of a barrier film including a resin substrate and an inorganic layer, the coating material has an oxygen barrier property sufficient for reducing the deterioration of the quantum dot phosphor, since EVOH has a particularly low oxygen permeability among resins.

The proportion of the structural unit derived from ethylene (ethylene content) in EVOH is not particularly limited, and can be selected as appropriate, taking into consideration the desired properties and the like of the wavelength conversion member. From the viewpoint of improving the oxygen barrier property, a low ethylene content is preferred; whereas from the viewpoint of improving the strength and water resistance, a high ethylene content is preferred. For example, the ethylene content in EVOH is preferably from 20% by mole to 50% by mole, more preferably from 25% by mole to 45% by mole, and still more preferably from 30% by mole to 40% by mole.

The average thickness of the coating material containing EVOH is, for example, preferably 20 µm or more, and more preferably 50 µm or more. When the average thickness is 20 µm or more, the coating material tends to have a sufficient function such as barrier property.

The average thickness of the coating material containing EVOH is, for example, preferably 150 µm or less, and more preferably 125 µm or more. When the average thickness is 150 µm or less, a decrease in the light transmittance tends to be reduced.

The coating material has an oxygen permeability of, for example, preferably 0.5 cm³/(m²·day·atm) or less, more preferably 0.3 cm³/(m²·day·atm) or less, and still more preferably 0.1 cm³/(m²·day atm) or less.

The oxygen permeability of the coating material can be measured using an oxygen permeability measuring apparatus (for example, OX-TRAN, manufactured by MOCON Inc.), under the conditions of a temperature of 20°C and a relative humidity of 65%.

The water vapor permeability of the coating material may be, for example, more than 0.1 g/(m²·day), or more than 0.1 g/(m²·day) but equal to or less than 0.3 g/(m²·day). In the wavelength conversion member according to the present disclosure, the wavelength conversion layer tends to have an excellent light resistance under both a high temperature environment as well as a high temperature and high humidity environment, even in the case of using a coating material having a relatively high water vapor permeability of more than 0.1 g/(m²·day).

A coating material having a water vapor permeability of 0.1 g/(m²·day) or less may also be used.

The water vapor permeability of the coating material can be measured using a water vapor permeability measuring apparatus (for example, AQUATRAN, manufactured by MOCON Inc.) under the environment of a temperature of 40°C and a relative humidity of 90%.

The wavelength conversion member according to the present disclosure preferably has a total light transmittance of 55% or more, more preferably 60% or more, and still more preferably 65% or more, from the viewpoint of further improving the utilization efficiency of light. The total light transmittance of the wavelength conversion member can be measured in accordance with the method described in JIS K 7136:2000.

Further, the wavelength conversion member according to the present disclosure preferably has a haze of 95% or more, more preferably 97% or more, and still more preferably 99% or more, from the viewpoint of further improving the utilization efficiency of light.
The haze of the wavelength conversion member can be measured in accordance the method described in JIS K 7136:2000.

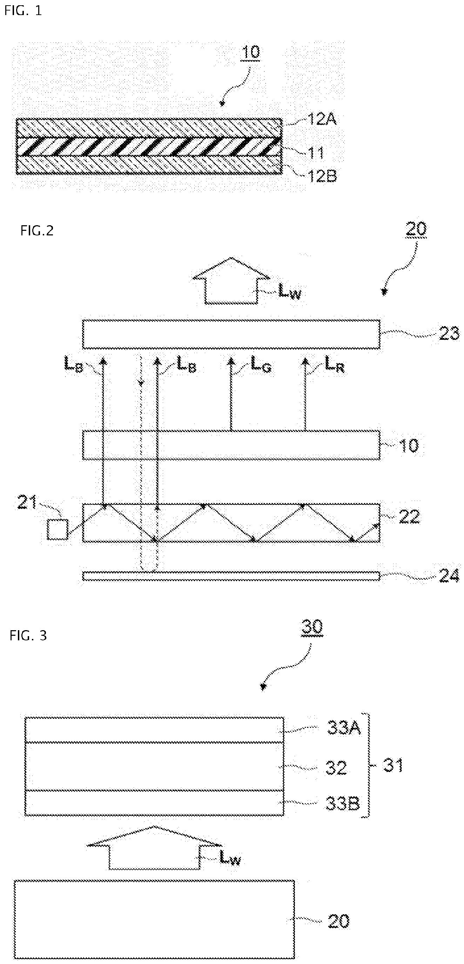

FIG. 1 shows one example of a schematic configuration of the wavelength conversion member. It is noted, however, that the wavelength conversion member according to the present disclosure is not limited the configuration shown in FIG. 1. Further, the sizes of the wavelength conversion layer and the coating materials shown in FIG. 1 are merely schematic, and the relative relationship between the respective sizes are not limited thereto. In each of the drawings, the same reference numerals denote the same members, and redundant descriptions may be omitted.

A wavelength conversion member 10 shown in FIG. 1 includes: a wavelength conversion layer 11, which is a cured product in the form of a film; and coating materials 12A and 12B, which are provided on both surfaces of the wavelength conversion layer 11 and are each in the form of a film. The types and the average thicknesses of the coating material 12A and the coating material 12B may be the same as, or different from, respectively.

The wavelength conversion member having the configuration shown in FIG. 1 can be produced, for example, by a known production method such as one shown below.

First, the curable composition is applied on one surface of a film-like coating material (hereinafter, also referred to as a "first coating material") which is continuously transported, to form a coating film. The method of applying the curable composition is not particularly limited, and examples thereof include a die coating method, a curtain coating method, an extrusion coating method, a rod coating method, and a roll coating method.

Subsequently, a film-like coating material (hereinafter, also referred to as a "second coating material") which is continuously transported is pasted on the thus formed coating film of the curable composition.

Thereafter, an active energy ray is irradiated from the side of either the first coating material or the second coating material that is capable of transmitting the active energy ray, to cure the coating film and to thereby form a wavelength conversion layer. The resultant is then cut into a prescribed size. In this manner, the wavelength conversion member having the configuration shown in FIG. 1 can be obtained.

In a case in which both the first coating material and the second coating material are not capable of transmitting an active energy ray, the wavelength conversion layer may be formed by irradiating the active energy ray to the coating film before pasting the second coating material thereon.

### <Backlight unit>

The backlight unit according to the present disclosure includes the wavelength conversion member according to the present disclosure as described above and a light source.

From the viewpoint of improving the color reproducibility, the backlight unit is preferably adapted to multi-wavelength light source. In a preferred embodiment, the backlight unit emits blue light having the light-emission central wavelength in the wavelength range of from 430 nm to 480 nm and having a light-emission intensity peak with a half width of 100 nm or less; green light having the light-emission central wavelength in the wavelength range of from 520 nm to 560 nm and having a light-emission intensity peak with a half width of 100 nm or less; and red light having the light-emission central wavelength in the wavelength range of from 600 nm to 680 nm and having a light-emission intensity peak with a half width of 100 nm or less. The half width of the light-emission intensity peak refers to a width of the peak measured at 1/2 in height of the peak, and refers to FWHM (Full Width at Half Maximum).

From the viewpoint of further improving the color reproducibility, the backlight unit preferably emits blue light having the light-emission central wavelength in the wavelength range of from 440 nm to 475 nm. From the same viewpoint, the backlight unit preferably emits green light having the light-emission central wavelength in the wavelength range of from 520 nm to 545 nm. From the same viewpoint, the backlight unit preferably emits red light having the light-emission central wavelength in the wavelength range of from 610 nm to 640 nm.

From the viewpoint of further improving the color reproducibility, the half width of the light-emission intensity peak of the blue light, the green light and the red light, emitted from the backlight unit, is preferably 80 nm or less, more preferably 50 nm or less, still more preferably 40 nm or less, particularly preferably 30 nm or less, and extremely preferably 25nm or less.

As regards the light source of the backlight unit, for example, a light source that emits blue light having the light-emission central wavelength in the wavelength range of from 430 nm to 480 nm may be used. The type of the light source may be LEDs (Light Emitting Diodes) or laser beams, for example. When a light source that emits blue light is used, the wavelength conversion member preferably contains at least a quantum dot phosphor R, which emits red light, and a quantum dot phosphor G, which emits green light. By this arrangement, white light is obtained by combining the red light and the green light emitted from the wavelength conversion member and the blue light that passes through the wavelength conversion member.

It is possible to use a light source that emits ultraviolet light having the light-emission central wavelength in the wavelength range of from 300 nm to 430 nm may be used as the light source of the backlight unit, for example. The type of the light source may be LEDs or laser beams, for example. When a light source that emits ultraviolet light is used, the wavelength conversion member preferably contains a quantum dot phosphor B, which emits blue light upon excitation with exciting light, together with a quantum dot phosphor R and a quantum dot phosphor G. By this arrangement, white light is obtained by combining the red light, the green light and the blue light, which are emitted from the wavelength conversion member.

The backlight unit according to the present disclosure may be edge-lighting type or direct-lighting type.

Fig. 2 shows one example of a schematic configuration of a backlight unit of edge-lighting type. However, the backlight unit according to the present disclosure is not limited to the configuration of Fig. 2. The size of the members in Fig. 2 is conceptual, and the relative relationship in actual size of the members is not limited thereto.

In Fig. 2, backlight unit 20 has light source 21 that emits blue light L_{B}; light guide plate 22 that guides blue light L_{B} emitted from light source 21 and emits the same; wavelength conversion member 10 that is disposed opposite to light guide plate 22; retroreflection member 23 that is disposed opposite to light guide plate 22 via wavelength conversion member 10; and reflection plate 24 that is disposed opposite to wavelength conversion member 10 via light guide plate 22. Wavelength conversion member 10 emits red light L_{R} and green light L_{G}, by using part of blue light L_{B} as exciting light, and emits red light L_{R}, green light L_{G}, and blue light L_{B} that is not used as exciting light. Retroreflection member 23 emits white light L_{W}, which is produced by combination of red light L_{R}, green light L_{G} and blue light L_{B}.

### <Image display device>

The image display device according to the present disclosure includes the backlight unit according to the present disclosure as described above. The type of the image display device is not particularly limited, and may be a liquid crystal display device, for example.

Fig. 3 shows one example of a schematic configuration of a liquid crystal display device. However, the liquid crystal display device according to the present disclosure is not limited to the configuration of Fig. 3. The size of the members in Fig. 3 is conceptual, and the relative relationship in actual size of the members is not limited thereto.

In Fig. 3, liquid crystal display device 30 includes backlight unit 20 and liquid crystal cell unit 31 that is disposed opposite to backlight unit 20. Liquid crystal cell unit 31 has a configuration in which liquid crystal cell 32 is disposed between polarization plate 33A and polarization plate 33B.

The drive system of liquid crystal cell 32 is not particularly limited, and examples thereof include TN (Twisted Nematic) system, STN (Super Twisted Nematic) system, VA (Vertical Alignment) system, IPS (In-Plane-Switching) system, and OCB (Optically Compensated Birefringence) system.

### < Curable Composition >

A curable composition according to the present disclosure contains: a quantum dot phosphor; a hindered amine-based compound; a polyfunctional (meth)acrylate compound; a polyfunctional thiol compound; and a photopolymerization initiator. The curable composition according to the present disclosure can be cured by irradiating an active energy ray.

The curable composition according to the present disclosure is used, for example, for producing a wavelength conversion member.

In the following, components which can be contained in the curable composition according to the present disclosure will now be described in detail.

### (Quantum Dot Phosphor)

The curable composition according to the present disclosure contains a quantum dot phosphor. The quantum dot phosphor is not particularly limited, and examples thereof include a particle containing at least one kind selected from the group consisting of II-VI compounds, III-V compounds, IV-VI compounds and IV compounds. From the viewpoint of light emission efficiency, the quantum dot phosphor preferably contains a compound that contains at least one of Cd or In.

Specific examples of the II-VI compound include CdSe, CdTe, CdS, ZnS, ZnSe, ZnTe, ZnO, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, CdZnSeS, CdZnSeTe, CdZnSTe, CdHgSeS, CdHgSeTe, CdHgSTe, HgZnSeS, HgZnSeTe and HgZnSTe.

Specific examples of the III-V compound include GaN, GaP, GaAs, GaSb, AlN, AlP, AlAs, AlSb, InN, InP, InAs, InSb, GaNP, GaNAs, GaNSb, GaPAs, GaPSb, AlNP, AINAs, AINSb, AlPAs, AlPSb, InNP, InNAs, InNSb, InPAs, InPSb, GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs and InAlPSb.

Specific examples of the IV-VI compound include SnS, SnSe, SnTe, PbS, PbSe, PbTe, SnSeS, SnSeTe, SnSTe, PbSeS, PbSeTe, PbSTe, SnPbS, SnPbSe, SnPbTe, SnPbSSe, SnPbSeTe and SnPbSTe.

Specific examples of the IV compound include Si, Ge, SiC and SiGe.

The quantum dot phosphor may have a core-shell structure. It is possible to improve the quantum efficiency of the quantum dot phosphor by making a band gap of the compound composing the shell broader than that of the compound composing the core. Examples of the combination of the core and the shell (core/shell) include CdSe/ZnS, InP/ZnS, PbSe/PbS, CdSe/CdS, CdTe/CdS and CdTe/ZnS.

The quantum dot phosphor may have a core-multi-shell structure, in which the shell is multi-layered. It is possible to further improve the quantum efficiency of the quantum dot phosphor by laminating one or more shells having a narrower band gap on the core having a wider band gap, and further laminating a shell having a wider band gap on the one or more shells.

The curable composition may contain one kind of the quantum dot phosphor singly, or two or more kinds of the quantum dot phosphors in combination. Examples of an aspect containing two or more kinds of quantum dot phosphors in combination include, for example, an aspect containing two or more kinds of quantum dot phosphors having different components and having the same average particle size, an aspect containing two or more kinds of quantum dot phosphors having different average particle size and having the same components, and an aspect containing two or more kinds of quantum dot phosphors having different components and average particle size. The light-emission central wavelength of the quantum dot phosphor can be changed by changing at least one of the component of the quantum dot phosphor or the average particle size.

For example, the curable composition may contain a quantum dot phosphor G having the light-emission central wavelength in the green wavelength range of from 520nm to 560nm, and a quantum dot phosphor R having the light-emission central wavelength in the red wavelength range of from 600nm to 680nm. When excitation light in the blue wavelength range of from 430nm to 480nm is irradiated to the wavelength conversion layer that is the cured product of the curable composition containing the quantum dot phosphor G and the quantum dot phosphor R, the quantum dot phosphor G and the quantum dot phosphor R emit green light and red light respectively. As a result, white light can be obtained by the green light and the red light emitted from the quantum dot phosphor G and the quantum dot phosphor R, and the blue light that passes through the wavelength conversion layer.

The quantum dot phosphor may be used in a state of a quantum dot phosphor dispersion liquid in which the quantum dot phosphor dispersed in a dispersion medium. Examples of the dispersion medium dispersing the quantum dot phosphor includes water, various organic solvents and monofunctional (meth)acrylate compounds.

Examples of the organic solvent usable as the dispersion medium include acetone, ethyl acetate, toluene, n-hexane and the like.

The monofunctional (meth)acrylate compound usable as the dispersion medium is not particularly limited as long as it is a liquid at room temperature (25°C), and examples of the monofunctional (meth)acrylate compound include isobornyl (meth)acrylate, dicyclopentanyl (meth)acrylate and the like.

Among these, from the viewpoint of eliminating the step of volatilizing the dispersion medium when curing the curable composition, the dispersion medium is preferably a monofunctional (meth)acrylate compound, more preferably a monofunctional (meth)acrylate containing an alicyclic structure, still more preferably at least one of isobornyl (meth)acrylate and dicyclopentanyl (meth)acrylate, and particularly preferably isobornyl (meth)acrylate.

In a case in which the monofunctional (meth)acrylate compound is used as the dispersion medium, the content ratio of the monofunctional (meth)acrylate compound and the polyfunctional (meth)acrylate compound in the curable composition on a mass basis (monofunctional (meth)acrylate compound/polyfunctional (meth)acrylate compound) is preferably from 0.01 to 0.30, more preferably from 0.02 to 0.20, and still more preferably from 0.05 to 0.20.

The proportion of the quantum dot phosphor in the quantum dot phosphor dispersion liquid on a mass basis is preferably from 1% by mass to 15% by mass, more preferably from 1% by mass to 14% by mass, and still more preferably from 2% by mass to 12% by mass.

In a case in which the proportion of the quantum dot phosphor in the quantum dot phosphor dispersion liquid on a mass basis is from 1% by mass to 15% by mass, the content of the quantum dot phosphor dispersion liquid in the curable composition is, for example, preferably from 0.5% by mass to 9% by mass, more preferably from 0.8% by mass to 8% by mass, and still more preferably from 1% by mass to 7% by mass with respect to the total amount of the curable composition. The content of the quantum dot phosphor in the curable composition is, for example, preferably from 0.05% by mass to 1.0% by mass, more preferably from 0.08% by mass to 0.8% by mass, and still more preferably from 0.1% by mass to 0.7% by mass, with respect to the total amount of the curable composition. When the content of the quantum dot phosphor is 0.05% by mass or more, there is a tendency that a sufficient emission intensity can be obtained in irradiating the wavelength conversion layer with excitation light, and when the content of the quantum dot phosphor is 1.0% by mass or less, there is a tendency that the aggregation of the quantum dot phosphor can be reduced.

### (Hindered Amine-based Compound)

The curable composition according to the present disclosure contains a hindered amine-based compound.

The hindered amine-based compound preferably contains, for example, a compound represented by the following Formula (II).

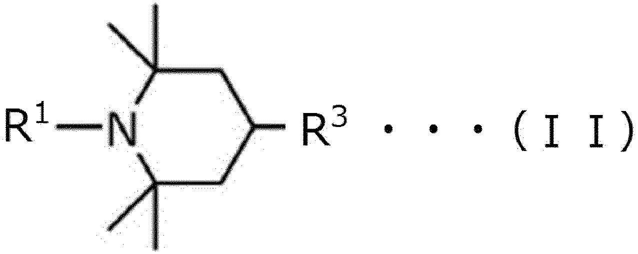

In Formula (II), each of R¹ and R³ independently represents a hydrogen atom or a substituent. Preferred examples of R¹ are the same as those described for R¹ in the above described Formula (I).

R³ is preferably a substituent having the ester structure (-O-C(= O)-).

In Formula (II), R³ preferably contains a polymerizable reactive group, and more preferably contains a (meth)acryloyl group. This enables to obtain a wavelength conversion layer which has a structure formed by copolymerization of the hindered amine-based compound with a polyfunctional (meth)acrylate compound, a polyfunctional thiol compound, and the like. As a result, it leads to a tendency that the exudation of the hindered amine-based compound, and the like can be reduced, and that the effects of the hindered amine-based compound are more suitably exhibited in the wavelength conversion layer.

The hindered amine-based compound is preferably a liquid at 20°C. This eliminates the need for performing a process of dissolving a solid hindered amine-based compound in a solvent, and then mixing with the respective components, thereby enabling to simplify the preparation of the curable composition.

Specific examples of the hindered amine-based compound is not particularly limited, and include, for example, tris(2,2,6,6-tetramethyl-4-piperidyl)benzene-1,3,5-tricarboxylate, tris(2,2,6,6-tetramethyl-4-piperidyl)-2-acetoxy propane-1,2,3-tricarboxylate, tris(2,2,6,6-tetramethyl-4-piperidyl)-2-hydroxypropane-1,2,3-tricarboxylate, tris(2,2,6,6-tetramethyl-4-piperidyl)triazine-2,4,6-tricarboxylate, tris(2,2,6,6-tetramethyl-4-piperidyl)butane-1,2,3-tricarboxylate, tetrakis(2,2,6,6-tetramethyl-4-piperidyl)propane-1,1,2,3-tetracarboxylate, tetrakis(2,2,6,6-tetramethyl-4-piperidyl)butane-1,2,3,4-tetracarboxylate, tetrakis(1,2,2,6,6-pentamethyl-4-piperidyl)butane-1,2,3,4-tetracarboxylate, 2-(3,5-di-t-butyl-4-hydroxybenzyl)-2-n-butylmalonic acid bis(1,2,2,6,6-pentamethyl-4-piperidyl), bis(2,2,6,6-tetramethyl-4-piperidyl) sebacate, bis(1,2,2,6,6-pentamethyl-4-piperidyl) sebacate, bis(1-undecanoxy-2,2,6,6-tetramethylpiperidin-4-yl) carbonate, 1,2,2,6,6-pentamethyl-4-piperidyl methacrylate, 2,2,6,6-tetramethyl-4-piperidyl methacrylate, compound which is represented by the following Formula (a) and in which R is a methyl group (1,2,3,4-butanetetracarboxylic acid, tetramethyl ester, reaction products with 1,2,2,6,6-pentamethyl-4-piperidinol and β,β,β',β'-tetramethyl-2,4,8,10-tetraoxaspiro[5.5]undecane-3,9-diethanol), and compound which is represented by the following Formula (a) and in which R is a hydrogen atom (1,2,3,4-butanetetracarboxylic acid, tetramethyl ester, reaction products with 2,2,6,6-tetramethyl-4-piperidinol and β,β,β',β'-tetramethyl-2,4,8,10-tetraoxaspiro[5.5]undecane-3,9-diethanol).

The curable composition may contain one kind of hindered amine-based compound singly, or may contain two or more kinds of hindered amine-based compounds in combination.

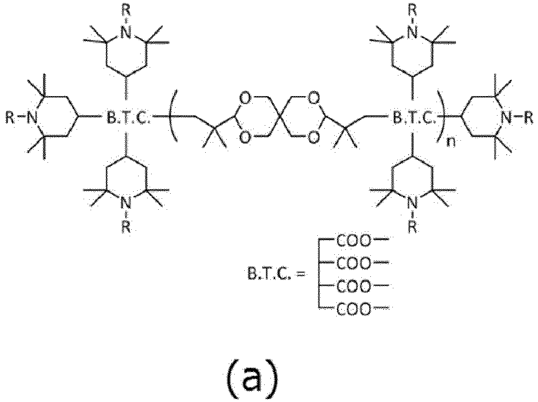

The content of the hindered amine-based compound in the curable composition is, for example, preferably from 0.1% by mass to 5% by mass, more preferably from 0.3% by mass to 4% by mass, and still more preferably from 0.5% by mass to 3% by mass, with respect to the total amount of the curable composition. When the content of the hindered amine-based compound is 0.1% by mass or more, there is a tendency that a wavelength conversion layer having an excellent light resistance under both a high temperature environment as well as a high temperature and high humidity environment can be produced. When the content of the hindered amine-based compound is 5% by mass or less, there is a tendency that the occurrence of bleed out can be reduced.

### (Polyfunctional (Meth)acrylate Compound)

The curable composition contains a polyfunctional (meth)acrylate compound. The polyfunctional (meth)acrylate compound may be a compound containing two or more (meth)acryloyl groups in one molecule.

Specific examples of the polyfunctional (meth)acrylate compound includes alkylene glycol di(meth)acrylates such as 1,4-butanediol di(meth)acrylate, 1,6-hexanediol di(meth)acrylate and 1,9-nonanediol di(meth)acrylate; polyalkylene glycol di(meth)acrylates such as polyethylene glycol di(meth)acrylate and polypropylene glycol di(meth)acrylate; tri(meth)acrylate compounds such as trimethylolpropane tri(meth)acrylate, ethylene oxide-added trimethylolpropane tri(meth)acrylate, and tris(2-acryloyloxyethyl)isocyanurate; tetra(meth)acrylate compounds such as ethylene oxide-added pentaerythritol tetra(meth)acrylate, trimethylolpropane tetra(meth)acrylate, and pentaerythritol tetra(meth)acrylate; (meth)acrylate compounds containing an alicyclic structure such as tricyclodecane dimethanol di(meth)acrylate, cyclohexane dimethanol di(meth)acrylate, 1,3-adamantane dimethanol di(meth)acrylate, hydrogenated bisphenol A (poly)ethoxy di(meth)acrylate, hydrogenated bisphenol A (poly)propoxydi(meth)acrylate, hydrogenated bisphenol F (poly)ethoxydi(meth)acrylate, hydrogenated bisphenol F (poly)propoxydi(meth)acrylate, hydrogenated bisphenol S (poly)ethoxydi(meth)acrylate, and hydrogenated bisphenol S (poly)propoxydi(meth)acrylate.

The polyfunctional (meth)acrylate compound may be a compound containing an alkyleneoxy group, and may be bifunctional (meth)acrylate compound containing an alkyleneoxy group.

The alkyleneoxy group is, for example, preferably an alkyleneoxy group having 2 to 4 carbon atoms, more preferably an alkyleneoxy group having 2 or 3 carbon atoms, and still more preferably an alkyleneoxy group having 2 carbon atoms.

The polyfunctional (meth)acrylic compound may contain a single kind of alkyleneoxy group, or may have two or more kinds thereof.

The polyfunctional (meth)acrylic compound containing an alkyleneoxy group may be a compound containing a polyalkyleneoxy group, which contains multiple alkyleneoxy groups.

When the polyfunctional (meth)acrylic compound contains an alkyleneoxy group, the number of the alkyleneoxy group in one molecule is preferably from 2 to 30, more preferably from 2 to 20, still more preferably from 3 to 10, and particularly preferably from 3 to 5.

In a case in which the polyfunctional (meth)acrylic compound contains an alkyleneoxy group, the compound preferably contains a bisphenol structure. This tends to improve the heat resistance of the wavelength conversion layer. Examples of the bisphenol structure include, for example, a bisphenol A structure and a bisphenol F structure, and, the bisphenol structure is preferably a bisphenol A structure.

Specific examples of the polyfunctional (meth)acrylic compound containing an alkyleneoxy group include alkoxyalkyl (meth)acrylates such as butoxyethyl (meth)acrylate; polyalkylene glycol monoalkyl ether (meth)acrylates such as diethylene glycol monoethyl ether (meth)acrylate, triethylene glycol monobutyl ether (meth)acrylate, tetraethylene glycol monomethyl ether (meth)acrylate, hexaethylene glycol monomethyl ether (meth)acrylate, octaethylene glycol monomethyl ether (meth)acrylate, nonaethylene glycol monomethyl ether (meth)acrylate, dipropylene glycol monomethyl ether (meth)acrylate, heptapropylene glycol monomethyl ether (meth)acrylate, and tetraethylene glycol monoethyl ether (meth)acrylate; polyalkylene glycol monoaryl ether (meth)acrylates such as hexaethylene glycol monophenyl ether (meth)acrylate; (meth)acrylate compounds containing a heterocycle such as tetrahydrofurfuryl (meth)acrylate; (meth)acrylate compounds containing a hydroxyl group such as triethylene glycol mono(meth)acrylate, tetraethylene glycol mono(meth)acrylate, hexaethylene glycol mono(meth)acrylate, and octapropylene glycol mono(meth)acrylate; (meth)acrylate compounds containing a glycidyl group such as glycidyl (meth)acrylate; polyalkylene glycol di(meth)acrylates such as polyethylene glycol di(meth)acrylate, and polypropylene glycol di(meth)acrylate; tri(meth)acrylate compounds such as ethylene oxide-added trimethylolpropane tri(meth)acrylate compound; tetra(meth)acrylate compounds such as ethylene oxide-added pentaerythritol tetra(meth)acrylate; bisphenol di(meth)acrylate compounds such as ethoxylated bisphenol A di(meth)acrylate, propoxylated bisphenol A di(meth)acrylate, and propoxylated ethoxylated bisphenol A di(meth)acrylate.

The poly(meth)acrylate compound containing an alkyleneoxy group is preferably ethoxylated bisphenol A di(meth)acrylate, propoxylated bisphenol A di(meth)acrylate, or propoxylated ethoxylated bisphenol A di(meth)acrylate, and more preferably ethoxylated bisphenol A di(meth)acrylate.

The content of poly(meth)acrylate compound in the curable composition is, for example, preferably from 20% by mass to 60% by mass, more preferably from 25% by mass to 50% by mass, and still more preferably from 35% by mass to 45% by mass, with respect to the total amount of the curable composition. When the content of poly(meth)acrylate compound is 20% by mass or more, there is a tendency that a decrease in adhesion between the coating material and the wavelength conversion layer can be suitably reduced, and the content of the poly(meth)acrylate compound is 60% or less, there is a tendency that a wavelength conversion layer has an excellent light resistance under both a high temperature environment as well as a high temperature and high humidity environment.

The proportion of the poly(meth) acrylate compound containing an alkyleneoxy group in the poly(meth)acrylate compound on a mass basis is preferably from 60% by mass to 100% by mass, and more preferably from 70% by mass to 100% by mass, and still more preferably from 80% by mass to 100% by mass.

In the curable composition, the content of the poly(meth)acrylate compound containing an alkyleneoxy group is preferably from 20% by mass to 60% by mass, and more preferably from 25% by mass to 50% by mass, and still more preferably from 35% by mass to 45% by mass.

### (Polyfunctional Thiol Compound)

The curable composition contains a polyfunctional thiol compound. When the curable composition cures, the ene-thiol reaction proceeds between the polyfunctional thiol compound and the poly(meth)acrylate compound, and there is a tendency that a heat resistance in the wave conversion layer can be more improved.

Specific examples of the polyfunctional thiol compound include ethylene glycol bis(3-mercaptopropionate), diethylene glycol bis(3-mercaptopropionate), tetraethylene glycol bis(3-mercaptopropionate), 1,2-propylene glycol bis(3-mercaptopropionate), diethylene glycol bis(3-mercaptobutyrate), 1,4-butanediol bis(3-mercaptopropionate), 1,4-butanediol bis(3-mercaptobutyrate), 1,8-octanediol bis (3-mercaptopropionate), 1,8-octanediol bis(3-mercaptobutyrate), hexanediol bisthioglycolate, trimethylolpropane tris(3-mercaptopropionate), trimethylolpropane tris(3 -mercaptobutyrate), trimethylolpropane tris(3-mercaptoisobutyrate), trimethylolpropane tris(2-mercaptoisobutyrate), trimethylolpropane tristhioglycolate, tris-[(3-mercaptopropionyloxy) -ethyl]-isocyanurate, trimethylolethane tris(3-mercaptobutyrate), pentaerythritol tetrakis(3-mercaptopropionate), pentaerythritol tetrakis(3-mercaptobutyrate), pentaerythritol tetrakis (3-mercaptoisobutyrate), pentaerythritol tetrakis (2-mercaptoisobutyrate), dipentaerythritol hexakis (3-mercaptopropionate), dipentaerythritol hexakis (2-mercaptopropionate), dipentaerythritol hexakis (3-mercaptobutyrate), dipentaerythritol hexakis (3-mercaptoisobutyrate), dipentaerythritol hexakis (2-mercaptoisobutyrate), pentaerythritol tetrakisthioglycolate, and dipentaerythritol hexakisthioglycolate.

The curable composition may contain a monofunctional thiol compound containing one thiol group in one molecule.

Specific examples of the monofunctional thiol compound include hexanethiol, 1-heptanethiol, 1-octanethiol, 1-nonanethiol, 1-decanethiol, 3-mercaptopropionic acid, methyl mercaptopropionate, methoxybutyl mercaptopropionate, octyl mercaptopropionate, tridecyl mercaptopropionate, 2-ethylhexyl-3-mercaptopropionate, and n-octyl-3-mercaptopropionate.

The content of the thiol compound (the total of the polyfunctional thiol compound, and the monofunctional thiol compound used as necessary, preferably the polyfunctional thiol compound) in the curable composition is, for example, preferably from 20% by mass to 70% by mass, more preferably from 30% by mass to 65% by mass, and still more preferably from 45% by mass to 60% by mass, with respect to the total amount of the curable composition. When the content of the thiol compound is 20% by mass or more, there is a tendency that a wavelength conversion layer has an excellent light resistance under both a high temperature environment as well as a high temperature and high humidity environment, and when the content of the thiol compound is 70% by less, there is a tendency that adhesion between the coating material and the wavelength conversion layer can be more excellent.

The proportion of the polyfunctional thiol compound in the total of the polyfunctional thiol compound and the monofunctional thiol compound used as necessary on a mass basis may be from 60% by mass to 100% by mass, from 70% by mass to 100% by mass, or from 80% by mass to 100% by mass.

The ratio of the number of a thiol group in the thiol compound (the total of the polyfunctional thiol compound, and the monofunctional thiol compound used as necessary, preferably the polyfunctional thiol compound) to the number of carbon-carbon double bond in the polyfunctional (meth)acrylate compound (the number of a thiol group/ the number of carbon-carbon double bond) is preferably from 0.5 to 5.0, more preferably from 1.0 to 4.0, and still more preferably from 1.5 to 3.5, and particularly preferably from 2.0 to 3.0.

### (Photopolymerization initiator)

The curable composition may contain a photopolymerization initiator. The photopolymerization initiator is not particularly limited, and examples thereof include a compound that generates radicals when it is exposed to active energy ray such as ultraviolet ray.

Specific examples of the photopolymerization initiator include aromatic ketone compounds such as benzophenone, N,N'-tetraalkyl-4,4-diaminobenzophenone, 2-benzyl-2-dimethylamino-1-(4-morpholinophenyl)-butanone-1, 2-methyl-1-[4-(methylthio)phenyl]-2-morpholino-propanone-1, 4,4'-bis(dimethylamino)benzophenone (referred to as "Michler's ketone"), 4,4'-bis(diethylamino)benzophenone, 4-methoxy-4'-dimethylaminobenzophenone, 1-hydroxy cyclohexyl phenyl ketone, 1-(4-isopropylphenyl)-2-hydroxy-2-methylpropan-1-one, 1-(4-(2-hydroxyethoxy)-phenyl)-2-hydroxy-2-methyl-1-propan-1-one, and 2-hydroxy-2-methyl-1-phenylpropan-1-one; quinone compounds such as alkyl anthraquinone and phenanthrenequinone; benzoin compounds such as benzoin and alkylbenzoin; benzoin ether compounds such as benzoin alkyl ether and benzoin phenyl ether; benzil derivatives such as benzil dimethylketal; 2,4,5-triaryl imidazole dimers such as 2-(o-chlorophenyl)-4,5-diphenyl imidazole dimer, 2-(o-chlorophenyl)-4,5-di(m-methoxyphenyl) imidazole dimer, 2-(o-fluorophenyl)-4,5-diphenyl imidazole dimer, 2-(o-methoxyphenyl)-4,5-diphenyl imidazole dimer, 2,4-di(p-methoxyphenyl)-5-phenyl imidazole dimer, and 2-(2,4-dimethoxyphenyl)-4,5-diphenyl imidazole dimer; acridine derivatives such as 9-phenyl acridine, and 1,7-(9,9'-acridinyl)heptane; oxime ester compounds such as 1,2-octanedione 1-[4-(phenylthio)-2-(O-benzoyloxime)], and ethanone 1-[9-ethyl-6-(2-methylbenzoyl)-9H-carbazol-3-yl]-1-(O-acetyloxime); coumarin compounds such as 7-diethylamino-4-methyl coumarin; thioxanthone compounds such as 2,4-diethyl thioxanthone; and acylphosphine oxide compounds such as 2,4,6-trimethylbenzoyl-diphenyl-phosphine oxide and 2,4,6-trimethylbenzoyl-phenyl-ethoxy-phosphine oxide. The curable composition may contain a single kind of the photopolymerization initiator, or may contain two or more kinds of the photopolymerization initiators in combination.

From the viewpoint of curability, the photopolymerization initiator is preferably at least one selected from the group consisting of an acylphosphine oxide compound, an aromatic ketone compound and an oxime ester compound, more preferably at least one selected from the group consisting of an acylphosphine oxide compound and an aromatic ketone compound, and still more preferably an acylphosphine oxide compound.

The content of the photopolymerization initiator in the curable composition is, for example, preferably from 0.1% by mass to 5% by mass, more preferably from 0.1% by mass to 3% by mass, and still more preferably from 0.1% by mass to 1.5% by mass, with respect to the total amount of the curable composition. When the content of the photopolymerization initiator is 0.1% by mass or more, sensitivity of the curable composition tends to be sufficient. When the content of the photopolymerization initiator is 5% by mass or less, effects on color hue or deterioration in storage stability of the curable composition tends to be reduced.

### (Liquid Medium)

The curable composition contains a liquid medium. The liquid medium means a medium in a liquid state at room temperature (25°C).

Specific examples of the liquid medium include ketone solvents such as acetone, methyl ethyl ketone, methyl-n-propyl ketone, methyl isopropyl ketone, methyl-n-butyl ketone, methyl isobutyl ketone, methyl-n-pentyl ketone, methyl-n-hexyl ketone, diethyl ketone, dipropyl ketone, diisobutyl ketone, trimethylnonanone, cyclohexanone, cyclopentanone, methylcyclohexanone, 2,4-pentanedione, and acetonylacetone; ether solvents such as diethyl ether, methyl ethyl ether, methyl-n-propyl ether, diisopropyl ether, tetrahydrofuran, methyl tetrahydrofuran, dioxane, dimethyl dioxane, ethylene glycol dimethyl ether, ethylene glycol diethyl ether, ethylene glycol di-n-propyl ether, ethylene glycol di-n-butyl ether, diethylene glycol dimethyl ether, diethylene glycol diethyl ether, diethylene glycol methyl ethyl ether, diethylene glycol methyl-n-propyl ether, diethylene glycol methyl-n-butyl ether, diethylene glycol di-n-propyl ether, diethylene glycol di-n-butyl ether, diethylene glycol methyl-n-hexyl ether, triethylene glycol dimethyl ether, triethylene glycol diethyl ether, triethylene glycol methyl ethyl ether, triethylene glycol methyl-n-butyl ether, triethylene glycol di-n-butyl ether, triethylene glycol methyl-n-hexyl ether, tetraethylene glycol dimethyl ether, tetraethylene glycol diethyl ether, tetraethylene glycol methyl ethyl ether, tetraethylene glycol methyl-n-butyl ether, tetraethylene glycol di-n-butyl ether, tetraethylene glycol methyl-n-hexyl ether, propylene glycol dimethyl ether, propylene glycol diethyl ether, propylene glycol di-n-propyl ether, propylene glycol di-n-butyl ether, dipropylene glycol dimethyl ether, dipropylene glycol diethyl ether, dipropylene glycol methyl ethyl ether, dipropylene glycol methyl-n-butyl ether, dipropylene glycol di-n-propyl ether, dipropylene glycol di-n-butyl ether, dipropylene glycol methyl-n-hexyl ether, tripropylene glycol dimethyl ether, tripropylene glycol diethyl ether, tripropylene glycol methyl ethyl ether, tripropylene glycol methyl- n-butyl ether, tripropylene glycol di-n-butyl ether, tripropylene glycol methyl-n-hexyl ether, tetrapropylene glycol dimethyl ether, tetrapropylene glycol diethyl ether, tetrapropylene glycol methyl ethyl ether, tetrapropylene glycol methyl-n-butyl ether, tetrapropylene glycol di-n-butyl ether, and tetrapropylene glycol methyl-n-hexyl ether; carbonate solvents such as propylene carbonate, ethylene carbonate, diethyl carbonate; ester solvents such as methyl acetate, ethyl acetate, n-propyl acetate, isopropyl acetate, n-butyl acetate, isobutyl acetate, sec-butyl acetate, n-pentyl acetate, sec-pentyl acetate, 3-methoxybutyl acetate, methylpentyl acetate, 2-ethylbutyl acetate, 2-ethylhexyl acetate, 2-(2-butoxyethoxy)ethyl acetate, benzyl acetate, cyclohexyl acetate, methyl cyclohexyl acetate, nonyl acetate, methyl acetoacetate, ethyl acetoacetate, diethylene glycol methyl ether acetate, diethylene glycol monoethyl ether acetate, dipropylene glycol methyl ether acetate, dipropylene glycol ethyl ether acetate, glycol diacetate, methoxytriethylene glycol acetate, ethyl propionate, n-butyl propionate, isoamyl propionate , diethyl oxalate, di-n-butyl oxalate, methyl lactate, ethyl lactate, n-butyl lactate, n-amyl lactate, ethylene glycol methyl ether propionate, ethylene glycol ethyl ether propionate, ethylene glycol methyl ether acetate , ethylene glycol ethyl ether acetate, propylene glycol methyl ether acetate, propylene glycol ethyl ether acetate, propylene glycol propyl ether acetate, γ-butyrolactone, and γ-valerolactone; aprotic polar solvents such as acetonitrile, N-methylpyrrolidinone, N-ethylpyrrolidinone, N-propylpyrrolidinone, N-butylpyrrolidinone, N-hexylpyrrolidinone, N-cyclohexylpyrrolidinone, N,N-dimethylformamide, N,N-dimethylacetamide, and dimethylsulfoxide; alcohol solvents such as methanol, ethanol, n-propanol, isopropanol, n-butanol, isobutanol, sec-butanol, t-butanol, n-pentanol, isopentanol, 2-methylbutanol, sec-pentanol, t-pentanol, 3-methoxybutanol, n-hexanol, 2-methylpentanol, sec-hexanol, 2-ethylbutanol, sec-heptanol, n-octanol, 2-ethylhexanol, sec-octanol, n-nonyl alcohol, n-decanol, sec-undecyl alcohol, trimethylnonyl alcohol, sec-tetradecyl alcohol, sec-heptadecyl alcohol, cyclohexanol, methylcyclohexanol, benzyl alcohol, ethylene glycol, 1,2-propylene glycol, 1,3-butylene glycol, diethylene glycol, dipropylene glycol, and triethylene glycol, tripropylene glycol; glycol monoether solvents such as ethylene glycol monomethyl ether, ethylene glycol monoethyl ether, ethylene glycol monophenyl ether, diethylene glycol monomethyl ether, diethylene glycol monoethyl ether, diethylene glycol mono-n-butyl ether, diethylene glycol mono-n-hexyl ether, triethylene glycol monoethyl ether, tetraethylene glycol mono-n-butyl ether, propylene glycol monomethyl ether, dipropylene glycol monomethyl ether, dipropylene glycol monoethyl ether, and tripropylene glycol monomethyl ether; terpene solvents such as terpinene, terpineol, myrcene, alloocimene, limonene, dipentene, pinene, carvone, ocimene, and ferrandrene; straight silicone oils such as dimethyl silicone oil, methylphenyl silicone oil, and methyl hydrogen silicone oil; modified silicone oils such as amino modified silicone oil, epoxy modified silicone oil, carboxy modified silicone oil, carbinol modified silicone oil, mercapto modified silicone oil, different functional group modified silicone oil, polyether modified silicone oil, methylstyryl modified silicone oil, hydrophilic special modified silicone oil, higher alkoxy modified silicone oil, higher fatty acid modified silicone oil, and fluorine modified silicone oil; saturated aliphatic monocarboxylic acids having 4 or more carbon atoms such as butanoic acid, pentanoic acid, hexanoic acid, heptanoic acid, octanoic acid, nonanoic acid, decanoic acid, undecanoic acid, dodecanoic acid, tridecanoic acid, tetradecanoic acid, pentadecanoic acid, hexadecanoic acid, heptadecanoic acid, octadecanoic acid, nonadecanoic acid, icosanoic acid, and eicosenoic acid; and unsaturated aliphatic monocarboxylic acids having 8 or more carbon atoms such as oleic acid, elaidic acid, linoleic acid, palmitoleic acid. In a case in which the curable composition contains the liquid medium, the curable composition may contain a single kind of the liquid medium, or may contain two or more kinds of the liquid mediums in combination.

In a case in which the curable composition contains the liquid medium, the content of the liquid medium in the curable composition is, for example, preferably from 1% by mass to 10% by mass, more preferably from 4% by mass to 10% by mass, and still more preferably from 4% by mass to 7% by mass, with respect to the total amount of the curable composition.

### (White Pigment)

The curable composition may contain a white pigment.

Specific examples of the white pigment include titanium oxide, barium sulfate, zinc oxide, and calcium carbonate. Among these, titanium oxide is preferred from the viewpoint of improving light scattering efficiency.

In a case in which the curable composition contains titanium oxide as the white pigment, the titanium oxide may be a rutile-type titanium oxide or an anatase-type titanium oxide, and is preferably a rutile-type titanium oxide.

The white pigment preferably has an average particle size of from 0.1 µm to 1 µm, more preferably from 0.2 µm to 0.8 µm, and still more preferably from 0.2 µm to 0.5 µm.

In the present disclosure, the average particle size of the white pigment can be measured as follows.

The white pigment extracted from the curable composition is dispersed in purified water containing a surfactant, to obtain a dispersion liquid. In a volume-based particle size distribution measured by a laser diffraction particle size distribution measuring apparatus (for example, SALD-3000J, manufactured by Shimadzu Corporation), using the thus prepared dispersion liquid, the value (median size (D50)) of the particle size at which accumulation from a small diameter side reaches 50% is defined as the average particle size of the white pigment. The white pigment can be extracted from the curable composition, for example, by a method in which the curable composition is diluted with a liquid medium, and the white pigment is precipitated by centrifugation or the like, followed by separating and collecting the pigment.

The average particle size of the white pigment included in the wavelength conversion layer can be obtained by observing the particles of the pigment using a scanning electron microscope, calculating a circle equivalent diameter (geometric mean of a longer diameter and a shorter diameter) for 50 particles, and determining the arithmetic mean value of the calculated diameters, as the average particle size.

In a case in which the curable composition contains the white pigment, the particles of the white pigment preferably have an organic matter layer containing an organic matter on at least a part of the surface thereof, from the viewpoint of reducing the aggregation of the white pigment. Examples of the organic matter to be contained in the organic matter layer include an organic silane, an organosiloxane, a fluorosilane, an organic phosphonate, an organic phosphoric acid compound, an organic phosphinate, an organic sulfonic acid compound, a carboxylic acid, a carboxylic acid ester, a carboxylic acid derivative, an amide, a hydrocarbon wax, a polyolefin, a polyolefin copolymer, a polyol, a polyol derivative, an alkanolamine, an alkanolamine derivative, and an organic dispersant.

The organic matter to be contained in the organic matter layer preferably contains a polyol, an organic silane and/or the like, and more preferably contains at least one of a polyol or an organic silane.

Specific examples of the organic silane include octyltriethoxysilane, nonyltriethoxysilane, decyltriethoxysilane, dodecyltriethoxysilane, tridecyltriethoxysilane, tetradecyltriethoxysilane, pentadecyltriethoxysilane, hexadecyltriethoxysilane, heptadecyltriethoxysilane, and octadecyltriethoxysilane.

Specific examples of the organosiloxane include polydimethylsiloxane (PDMS) terminated with a trimethylsilyl functional group, polymethylhydrosiloxane (PMHS), and a polysiloxane derived from PMHS by functionalization (by hydrosilylation) of PMHS with an olefin.

Specific examples of the organic phosphonate include: n-octylphosphonic acid and esters thereof; n-decylphosphonic acid and esters thereof; 2-ethylhexylphosphonic acid and esters thereof; and camphylphosphonic acid and esters thereof.

Specific examples of the organic phosphoric acid compound include: organic acidic phosphates, organic pyrophosphates, organic polyphosphates, and organic metaphosphates; and salts thereof.

Specific examples of the organic phosphinate include n-hexylphosphinic acid and esters thereof; n-octylphosphinic acid and esters thereof; di-n-hexylphosphinic acid and esters thereof; and di-n-octylphosphinic acid and esters thereof.

Specific examples of the organic sulfonic acid compound include: alkyl sulfonic acids such as hexylsulfonic acid, octylsulfonic acid, and 2-ethylhexylsulfonic acid; and salts of these alkyl sulfonic acids with metallic ions such as sodium, calcium, magnesium, aluminum and titanium ions, with ammonium ion, or with organic ammonium ions such as triethanol ammonium ion.

Specific examples of the carboxylic acid include maleic acid, malonic acid, fumaric acid, benzoic acid, phthalic acid, stearic acid, oleic acid, and linoleic acid.

Specific examples of the carboxylic acid ester include esters and partial esters produced by the reaction of any of the above described carboxylic acids with a hydroxy compound such as ethylene glycol, propylene glycol, trimethylolpropane, diethanolamine, triethanolamine, glycerol, hexanetriol, erythritol, mannitol, sorbitol, pentaerythritol, bisphenol A, hydroquinone, or phloroglucinol.

Specific examples of the amide include stearic acid amide, oleic acid amide, and erucic acid amide.

Specific examples of the polyolefin and the polyolefin copolymer include polyethylene, polypropylene or copolymers of ethylene with one kind or two or more kinds of compounds selected from the group consisting of propylene, butylene, vinyl acetate, acrylate, acrylamide, and the like.

Specific examples of the polyol include glycerol, trimethylolethane, and trimethylolpropane.

Specific examples of the alkanolamine include diethanolamine and triethanolamine.

Specific examples of the organic dispersant include citric acid, polyacrylic acid, polymethacrylic acid, and polymeric organic dispersants containing a functional group such as an anionic functional group, a cationic functional group, a zwitterionic functional group, or a non-ionic functional group.

When the aggregation of the white pigment in the curable composition is reduced, dispersibility of the white pigment in the wavelength conversion layer tends to improve.

The white pigment may have a metal oxide layer containing a metal oxide on at least a part of the surface thereof. Examples of the metal oxide to be contained in the metal oxide layer include silicon dioxide, aluminum oxide, zirconia, phosphoria, and boria. The metal oxide layer may be composed of one layer, or may be composed of two or more layers. In a case in which the white pigment has a metal oxide layer composed of two layers, the metal oxide layer preferably includes a first metal oxide layer containing silicon dioxide and a second metal oxide layer containing aluminum oxide.

When the white pigment has the metal oxide layer, the dispersibility of the white pigment in the wavelength conversion layer tends to improve.

The white pigment may have the organic matter layer and the metal oxide layer. In this case, it is preferred that the metal oxide layer and the organic matter layer are provided on the surface of the white pigment, in the order mentioned. In a case in which the white pigment has the organic matter layer and the metal oxide layer composed of two layers, it is preferred that the first metal oxide layer containing silicon dioxide, the second metal oxide layer containing aluminum oxide, and the organic matter layer are provided on the surface of the white pigment, in the order mentioned.

In a case in which the curable composition contains the white pigment, the content of the white pigment in the curable composition is, for example, preferably from 0.05% by mass to 1.0% by mass, more preferably from 0.1% by mass to 1.0% by mass, and still more preferably from 0.2% by mass to 0.5% by mass, with respect to the total amount of the curable composition.

### (Other Components)

The curable composition may further contain other components such as a polymerization inhibitor, a silane coupling agent, a surfactant, an adhesion imparting agent, and an antioxidant. The curable composition may contain one kind of each of such other components singly, or two or more kinds thereof in combination.

If necessary, the curable composition may contain a (meth)allyl compound.

### (Method of Preparing Curable Composition)

The curable composition can be prepared, for example, by mixing the quantum dot phosphor, the hindered amine-based compound, the polyfunctional (meth)acrylate compound, the polyfunctional thiol compound and the photopolymerization initiator, as well as any of the other components described above, if necessary, by an ordinary method. The quantum dot phosphor may be mixed in a state dispersed in a dispersion medium.

### < Cured Product >

A cured product according to the present disclosure is obtained by curing the above described curable composition according to the present disclosure. The cured product according to the present disclosure can be used as the wavelength conversion layer, which is a component constituting the wavelength conversion member. The preferred conditions for producing the cured product using the curable composition, the preferred physical properties of the cured product, and the like are the same as the preferred conditions for producing the wavelength conversion layer, the preferred physical properties of the wavelength conversion layer, and the like, described above.

### EXAMPLES

The present invention will now be specifically described, with reference to Examples. However, the invention is in no way limited to these Examples.

### < Examples 1 to 4 and Comparative Examples 1 to 4 >

### (Preparation of Curable Compositions)

The respective components shown in Table 1 were mixed at the blending amounts (unit: parts by mass) shown in Table 1, to obtain each of the curable compositions of Examples 1 to 4 and Comparative Examples 1 to 4. In Table 1, the description "-" means that the corresponding component was not incorporated.

Ethoxylated bisphenol A diacrylate (ABE-300, manufactured by Shin Nakamura Chemical Co., Ltd., EO: 3mol) was used as the polyfunctional (meth)acrylate compound.

Pentaerythritol tetrakis(3-mercaptopropionate) (PEMP, manufactured by SC Organic Chemical Co., Ltd.) was used as the polyfunctional thiol compound.

2,4,6-Trimethylbenzoyl-diphenyl-phosphine oxide (IRGACURE TPO, manufactured by BASF Japan Ltd.) was used as the photopolymerization initiator.

Further, a dispersion liquid of a quantum dot phosphor G (peak wavelength: 526 nm, half width: 25 nm, emitting green light) which is a CdSe/ ZnS (core/ shell) quantum dot phosphor, and a dispersion liquid of a quantum dot phosphor R (peak wavelength: 625 nm, half width: 46 nm, emitting red light) which is an InP/ ZnS (core/ shell) quantum dot phosphor, were used as the quantum dot phosphor dispersion liquids. Isobornyl acrylate was used as the dispersion medium for these dispersion liquids. The concentrations of the quantum dot phosphors in these dispersion liquids are both 10% by mass.

Further, titanium oxide (TI-PURE R-706, manufactured by The Chemours Company, particle size: 0.36 µm) was used as the white pigment. On the surface of the titanium oxide, the first metal oxide layer containing silicon oxide, the second metal oxide layer containing aluminum oxide, and the organic matter layer containing a polyol compound are provided, in the order mentioned.

Further, tetrakis(1,2,2,6, 6-pentamethyl-4-piperidyl)butane-1,2,3,4-tetracarboxylate (LA-52, manufactured by ADEKA Corporation), bis(1-undecanoxy-2,2,6,6-tetramethylpiperidin-4-yl) carbonate (LA-81, manufactured by ADEKA Corporation), and 1,2,2,6,6-pentamethyl-4-piperidylmethacrylate (LA-82, manufactured by ADEKA Corporation) were used as the hindered amine-based compounds.

Further, IRGANOX 1010 (manufactured by BASF Japan Ltd.) and IRGANOX 1035 (manufactured by BASF Japan Ltd.) were used as hindered phenolic antioxidants.

**[Table 1]**

| | | Example 1 | Example 2 | Example 3 | Example 4 | Comparative Example 1 | Comparative Example 2 | Comparative Example 3 | Comparative Example 4 |
|---|---|---|---|---|---|---|---|---|---|
| Polyfunctional (meth)acrylate compound | Ethoxylated bisphenol A diacrylate | 37.4 | 37.4 | 37.4 | 37.4 | 37.8 | 37.4 | 37.4 | 92.5 |
| Polyfunctional thiol compound | Pentaerythritol tetrakis(3 -mercaptopropionate) | 56.1 | 56.1 | 56.1 | 55.5 | 56.7 | 56.1 | 56.1 | - |
| Photopolymerization initiator | 2,4,6-Trimethylbenzoyl-diphenyl-phosphine oxide | 0.5 | 0.5 | 0.5 | 0.5 | 0.5 | 0.5 | 0.5 | 0.5 |
| White pigment | Titanium oxide | 0.5 | 0.5 | 0.5 | 0.5 | 0.5 | 0.5 | 0.5 | 0.5 |
| Quantum dot phosphor dispersion liquids | Dispersion liquid of quantum dot G | 3.0 | 3.0 | 3.0 | 3.0 | 3.0 | 3.0 | 3.0 | 3.0 |
| | Dispersion liquid of quantum dot R | 1.5 | 1.5 | 1.5 | 1.5 | 1.5 | 1.5 | 1.5 | 1.5 |
| Hindered amine-based compounds | LA-52 | 1.0 | - | - | - | - | - | - | - |
| | LA-81 | - | 1.0 | - | - | - | - | - | - |
| | LA-82 | - | - | 1.0 | 2.0 | - | - | - | 2.0 |
| Hindered phenolic antioxidants | IRGANOX 1010 | - | - | - | - | - | 1.0 | - | - |
| | IRGANOX 1035 | - | - | - | - | - | - | 1.0 | - |

### (Production of Wavelength Conversion Members)

Each of the curable compositions obtained as described above was coated on a PET film having an average thickness of 125 µm (A4300, manufactured by Toyobo Co., Ltd) (coating material), to form a coating film. On the thus formed coating film, another PET film which is the same as one used above was pasted. Thereafter, UV light was irradiated (at an irradiation dose of 1,000 mJ/cm²) using a UV light irradiation apparatus (manufactured by Eye Graphics Co., Ltd.), to obtain each wavelength conversion member in which the coating materials are disposed on both surfaces of a wavelength conversion layer.

### < Evaluation >

Using each of the wavelength conversion members obtained in Examples 1 to 4 and Comparative Examples 1 to 4, relative emission intensity retention was determined as follows, and the light resistance under a high temperature environment (high temperature light resistance) and the light resistance under a high temperature and high humidity environment (high temperature/ high humidity light resistance), as well as edge deterioration were evaluated for each wavelength conversion member. The results are shown in Table 2.

A higher numerical value of the relative emission intensity retention in Table 2 indicates that the corresponding wavelength conversion member has a better high temperature light resistance or a better high temperature/ high humidity light resistance. Further, a lower numerical value of the edge deterioration in Table 2 indicates that the corresponding wavelength conversion member has a better high temperature light resistance or a better high temperature/ high humidity light resistance.

### (Evaluation of High Temperature Light Resistance)

Each of the wavelength conversion members obtained as described above was cut into a shape having a diameter of 17 mm, to prepare an evaluation sample. The initial emission intensity of each evaluation sample was measured using a fiber multichannel spectrometer (OCEANVIEW, manufactured by Ocean Photonics, Inc.).

Next, each evaluation sample was set to a high-brightness tester, LIGHT BOX (manufactured by Nanosys Inc.) (LED peak wavelength: 448 nm), and a test was performed under the environment of an illuminance of 150 mW/cm² and a thermostatic chamber temperature of 85°C. Two hundred hours later, the evaluation sample was taken out of the chamber, and the relative emission intensity retention of each wavelength conversion member was calculated in accordance with the following Formula.
Relative emission intensity retention: (RLb1/RLa) × 100
RLa: initial relative emission intensity
RLb1: relative emission intensity under the environment of 150 mW/cm² and 85°C, after 200 hours later

### (Evaluation of High Temperature/ High Humidity Light Resistance)

Each of the wavelength conversion members obtained as described above was cut into a shape having a diameter of 17 mm, to prepare an evaluation sample. The initial emission intensity of each evaluation sample was measured using a fiber multichannel spectrometer (OCEANVIEW, manufactured by Ocean Photonics, Inc.).

Next, each evaluation sample was set to the high-brightness tester, LIGHT BOX (manufactured by Nanosys Inc.) (LED peak wavelength: 448 nm), and a test was performed under the environment of an illuminance of 10 mW/cm², a thermostatic chamber temperature of 44°C, and a RH of 70%. Two hundred hours later, the evaluation sample was taken out of the chamber, and the relative emission intensity retention of each wavelength conversion member was calculated in accordance with the following Formula.
Relative emission intensity retention: (RLb2/RLa) × 100
RLa: initial relative emission intensity
RLb2: relative emission intensity under the environment of 10 mW/cm², 44°C and 70%, after 200 hours later

### (Edge Deterioration)

Each of the wavelength conversion members obtained as described above was cut into a shape having a diameter of 17 mm, to prepare two evaluation samples.

Next, one of the thus prepared evaluation samples was set to the high-brightness tester, LIGHT BOX (manufactured by Nanosys Inc.) (LED peak wavelength: 448 nm), and a test was performed under the environment of an illuminance of 150 mW/cm² and a thermostatic chamber temperature of 85°C. Two hundred hours later, the evaluation sample was taken out of the chamber, and a distance (mm) from the edge of the sample to the end of a non-light emitting portion was measured, to evaluate the high temperature light resistance.

Further, another evaluation sample prepared above was set to the high-brightness tester, LIGHT BOX (manufactured by Nanosys Inc.) (LED peak wavelength: 448 nm), and a test was performed under the environment of an illuminance of 10 mW/cm², a thermostatic chamber temperature of 44°C, and a RH of 70%. Two hundred hours later, the evaluation sample was taken out of the chamber, and the distance (mm) from the edge of the sample to the end of the non-light emitting portion was measured, to evaluate the high temperature/ high humidity light resistance.

### (Calculation of FT-IR Peak Area Ratio and Reaction Rate)

The surface of the wavelength conversion layer in each of the wavelength conversion members obtained as described above was analyzed by ATR, using an FT-IR Spectrometer (manufactured by Perkin Elmer). At this time, the PET films were peeled off from each wavelength conversion member, and the surface of the cured product was analyzed by ATR. The background measurement was carried out by measuring air, the FT-IR measurement was carried out under the condition of a cumulative number of 16 times, and the FT-IR peak area ratio (V1/V2) was calculated in accordance with the following VI and V2.
VI: the peak area of the peak (peak wavelength: 1,637 cm⁻¹) attributed to C=C stretching vibration
V2: the peak area of the peak (peak wavelength: 2,569 cm⁻¹) attributed to S-H stretching vibration

**[Table 2]**

| | | Example 1 | Example 2 | Example 3 | Example 4 | Comparative Example 1 | Comparative Example 2 | Comparative Example 3 | Comparative Example 4 |
|---|---|---|---|---|---|---|---|---|---|
| Relative emission intensity retention (%) | High temperature light resistance | 52 | 33 | 59 | 68 | 13 | 15 | 14 | 10 |
| | High temperature/ high humidity light resistance | 78 | 54 | 90 | 98 | 52 | 49 | 50 | 25 |
| Edge deteriora tion (mm) | High temperature light resistance | 1.2 | 1.6 | 1.11 | 0.51 | >2.0 | >2.0 | >2.0 | >3.0 |
| | High temperature/ high humidity light resistance | 0.6 | 0.7 | 0.51 | 0.43 | 0.8 | 0.9 | 0.9 | >2.0 |
| V1/V2 | | 0.000055 | 0.000060 | 0.000047 | 0.000044 | 0.000050 | 0.000101 | 0.000098 | - |

As can be seen from Table 2, the wavelength conversion members of Examples 1 to 4 showed higher values of the relative emission intensity retention and lower values of the edge deterioration, as compared to those of Comparative Examples 1 to 4. Accordingly, the wavelength conversion members of Examples 1 to 4 had a better high temperature light resistance and a better high temperature/ high humidity light resistance than those of Comparative Examples 1 to 4.

In particular, the wavelength conversion members of Examples 1 to 4 showed much higher values of the relative emission intensity retention and much lower values of the edge deterioration, as compared to those of Comparative Example 4. Therefore, it has been found out that the wavelength conversion members of Examples 1 to 4 have a favorable high temperature light resistance and high temperature/ high humidity light resistance, due to including a wavelength conversion layer having both a structure derived from a hindered amine-based compound and a sulfide structure.

All publications, patent applications, and technical standards mentioned in the present specification are incorporated herein by reference to the same extent as if each individual publication, patent application, or technical standard was specifically and individually indicated to be incorporated by reference.

## Claims

1. A wavelength conversion member comprising a wavelength conversion layer,
the wavelength conversion layer comprising a quantum dot phosphor, and having a structure derived from a hindered amine-based compound, and a sulfide structure.

2. A wavelength conversion member comprising a wavelength conversion layer,
the wavelength conversion layer comprising a quantum dot phosphor and having a structure derived from a hindered amine-based compound,
wherein a ratio (V1/V2) of a peak area (VI) attributed to C = C stretching vibration to a peak area (V2) attributed to S-H stretching vibration, in the wavelength conversion layer, as measured by a Fourier transformation infrared spectrophotometer, is 0.00052 or less.

3. The wavelength conversion member according to claim 2, wherein the wavelength conversion layer has a sulfide structure.

4. The wavelength conversion member according to any one of claims 1 to 3, wherein the wavelength conversion layer has a structure formed by copolymerization of the hindered amine-based compound.

5. The wavelength conversion member according to claim 4, wherein the structure formed by copolymerization of the hindered amine-based compound contains a structural unit represented by the following Formula (I): 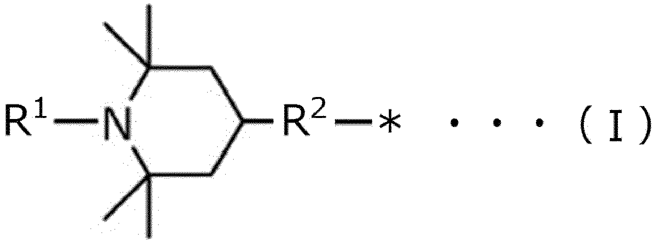 wherein in Formula (I), R¹ represents a hydrogen atom or a substituent; R² represents a linking group; and * represents a binding site.

6. The wavelength conversion member according to any one of claims 1 to 5, wherein the hindered amine-based compound comprises a compound represented by the following Formula (II): 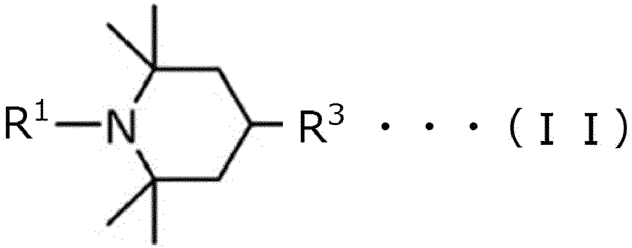 wherein in Formula (II), each of R¹ and R³ independently represents a hydrogen atom or a substituent.

7. The wavelength conversion member according to any one of claims 1 to 6, wherein the wavelength conversion layer has an alkyleneoxy structure.

8. The wavelength conversion member according to any one of claims 1 to 7, wherein the wavelength conversion member is a film.

9. The wavelength conversion member according to any one of claims 1 to 8, wherein the wavelength conversion member is used for displaying an image.

10. The wavelength conversion member according to any one of claims 1 to 9, wherein the quantum dot phosphor comprises a compound containing at least one of Cd or In.

11. The wavelength conversion member according to any one of claims 1 to 10, wherein the wavelength conversion member further comprises a coating material that coats at least a part of the wavelength conversion layer.

12. A back light unit comprising:
the wavelength conversion member according to any one of claims 1 to 11; and
a light source.

13. An image display device comprising the back light unit according to claim 12.

14. A curable composition comprising:
a quantum dot phosphor;
a hindered amine-based compound;
a polyfunctional (meth)acrylate compound;
a polyfunctional thiol compound; and
a photopolymerization initiator.

15. The curable composition according to claim 14, wherein the hindered amine-based compound comprises a compound represented by the following Formula (II): 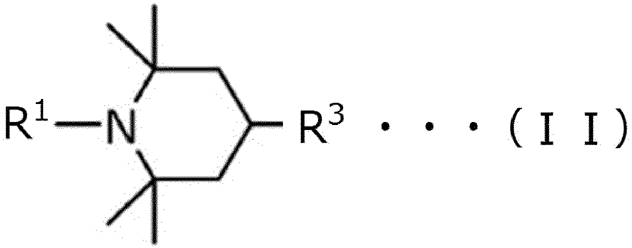 wherein in Formula (II), each of R¹ and R³ independently represents a hydrogen atom or a substituent.

16. The curable composition according to claim 15, wherein R³ in the compound represented by the Formula (II) comprises a polymerizable reactive group.

17. The curable composition according to claim 16, wherein the polymerizable reactive group is a (meth)acryloyl group.

18. The curable composition according to any one of claims 14 to 17, wherein the hindered amine-based compound is liquids at 20°C.

19. The curable composition according to any one of claims 14 to 18, wherein the quantum dot phosphor comprises a compound containing at least one of Cd or In.

20. The curable composition according to any one of claims 14 to 19, wherein the curable composition is used for forming a film.

21. The curable composition according to any one of claims 14 to 20, wherein the curable composition is used for producing a wavelength conversion member.

22. A cured product obtained by curing the curable composition according to any one of claims 14 to 21.
